# EUROPÄISCHE PATENTANMELDUNG

(11) **EP 0 663 598 A2**
(43) Veröffentlichungstag der Anmeldung: **19.07.1995**
(21) Anmeldenummer: 94117805.5
(22) Anmeldetag: 11.11.1994
(51) Int. Cl.: G01R 19/00

(54) **Vorrichtung zur Erfassung von Stossströmen an Blitzableitern oder dergleichen**

(30) Priorität: 15.01.1994 DE 4401069
(71) Anmelder: OBO Bettermann OHG, D-58710 Menden (DE)
(72) Erfinder: Jordan, Ernst-Günter, D-58710 Menden (DE)
(74) Vertreter: Patentanwälte Dipl.-Ing. Conrad Köchling Dipl.-Ing. Conrad-Joachim Köchling

(57) **Zusammenfassung**

Um eine Vorrichtung zur Erfassung von Stoßströmen an Blitzableitern, Überspannungsableitern oder anderen von Stoßströmen oder von impulsförmigen Strömen (Kurzschluß- oder Erdschlußströmen) durchflossenen elektrischen Leitern, wobei ein mit Speicherdaten belegter magnetisierbarer Datenträger in einer räumlichen Zuordnung zu einem von Stoßströmen durchströmbaren elektrischen Leiter angeordnet ist, so daß im Falle eines Stoßstromes mindestens eine mit Speicherdaten belegte Zone des Datenträgers in dem durch den Stoßstrom um den Leiter entstehenden Magnetfeld angeordnet ist zu schaffen, mit der es möglich ist, Überspannungsereignisse quantitativ und qualitativ über einen längeren Zeitraum zu erfassen und solche Ereignisse auch zuordnen zu können, wird vorgeschlagen, daß der Datenträger (2) relativ zum elektrischen Leiter (1) kontinuierlich oder in Stufen diskontinuierlich über den Verlauf einer Erfassungszeit derart verstellbar ist, daß entsprechend dem Zeitablauf jeweils andere auf die erste mit Speicherdaten belegte Zonen in dem durch einen Stoßstrom um den Leiter (1) entstehenden Magnetfeld angeordnet sind.

## Beschreibung

Die Erfindung betrifft eine Vorrichtung zur Erfassung von Stoßströmen an Blitzableitern, Überspannungsableitern oder anderen von Stoßströmen oder von impulsförmigen Strömen (Kurzschluß- oder Erdschlußströmen) durchflossenen elektrischen Leitern, wobei ein mit Speicherdaten belegter magnetisierbarer Datenträger in einer räumlichen Zuordnung zu einem von Stoßströmen durchströmbaren elektrischen Leiter angeordnet ist, so daß im Falle eines Stoßstromes mindestens eine mit Speicherdaten belegte Zone des Datenträgers in dem durch den Stoßstrom um den Leiter entstehenden Magnetfeld angeordnet ist.

Eine derartige Vorrichtung ist beispielsweise aus der DE 38 23 389 C1 bekannt. Die dort beschriebene Vorrichtung ist geeignet, ein Überspannungsereignis festzustellen, ohne daß jedoch die Anzahl von Ereignissen und die zeitliche Abfolge von Ergeignissen festgehalten werden könnte. Es ist lediglich möglich, das der Größenordnung nach stärkste Ereignis zu erfassen. Auf diese Weise kann zwar der Beweis geführt werden, daß ein Ableiter über Jahre hinaus seine Aufgabe erfüllt hat, jedoch ist es nicht möglich, die Ereignisse im einzelen aufzugliedern und zeitlich zuzuordnen.

Ausgehend von diesem Stand der Technik liegt der Erfindung die Aufgabe zugrunde, eine Vorrichtung gattungsgemäßer Art zu schaffen, mit der es möglich ist, Überspannungsereignisse quantitativ und qualitativ über einen längeren Zeitraum zu erfassen und solche Ereignisse auch zuordnen zu können.

Zur Lösung dieser Aufgabe wird vorgeschlagen, daß der Datenträger relativ zum elektrischen Leiter kontinuierlich oder in Stufen diskontinuierlich über den Verlauf einer Erfassungszeit derart verstellbar ist, daß entsprechend dem Zeitablauf jeweils andere auf die erste mit Speicherdaten belegte Zone folgende mit Speicherdaten belegte Zonen in dem durch einen Stoßstrom um den Leiter entstehenden Magnetfeld angeordnet sind.

Der Datenträger kann im Prinzip beliebige Form haben, wobei es lediglich erforderlich ist, den Datenträger so anzuordnen und zu schützen, daß lediglich eine für den Ereignisfall vorgesehene mit Speicherdaten belegte Zone jeweils im Einflußbereich des von Stoßströmen durchfließbaren elektrischen Leiters angeordnet ist, und den Datenträger entweder kontinuierlich oder auch diskontinuierlich im Minuten-, Stunden- oder Tagesrhythmus derart zu verstellen, daß nach Ablauf einer ersten Zeitperiode die erste mit Speicherdaten belegte Zone ausgeblendet und eine folgende mit Speicherdaten belegte Zone eingeblendet wird, die dann zur Aufnahme von weiteren Überspannungsereignissen bereit ist. Durch diese Ausbildung ist eine eindeutige zeitliche Zuordnung von Überspannungsereignissen möglich, wobei zudem auch nicht nur das stärkste Überspannungsereignis, sondern jedes Überspannungsereignis aufgezeichnet werden kann. Die Abfrage des Datenträgers kann mit geeigneten Lesegeräten erfolgen.

Eine bevorzugte Weiterbildung wird darin gesehen, daß der Datenträger eine mit einem Drehantrieb gekoppelte Scheibe ist.

Der Datenträger kann beispielsweise mit einer Halterung an einem Blitzableiter oder dergleichen elektrischen Leiter befestigt werden, wobei der Datenträger quer von dem entsprechenden Leiter einseitig abragend gehalten ist.

Desweiteren ist bevorzugt vorgesehen, daß der Datenträger scheiben- oder plattenförmig ausgebildet und quer von einem von Stoßstrom durchströmbaren Leiter abragend gehaltert ist, wobei der Datenträger an seiner großflächigen Ober- und Unterseite mit einer Abschirmung zur Abschirmung gegen das Magnetfeld des Leiters versehen ist, die lediglich einen schmalen, zum Leiter hin gerichteten Schlitz aufweist, durch den jeweils die mit Speicherdaten belegte Zone definiert ist, die in dem um den Leiter entstehenden Magnetfeld von diesem beeinflußbar ist.

Durch diese Anordnung ist in einfacher Weise die Ausblendung und Einblendung von entsprechenden mit Speicherdaten belegten Zonen durch Drehung des Datenträgers um eine mittige Achse möglich, wobei die Drehachse des Datenträgers quer zum Verlauf des elektrischen Leiters und orthogonal zur rechtwinklig vom Leiter abragenden Scheibenfläche gerichtet ist.

Desweiteren ist bevorzugt vorgesehen, daß der Datenträger mit einer eigenen Energiequelle, vorzugsweise einer Solarzelle, zur Versorgung des Drehantriebes ausgestattet ist. Dabei kann bevorzugt vorgesehen sein, daß die Solarzelle durch eine bei Inbetriebnahme entfernbare Schutzfolie abgedeckt ist.

Besonders bevorzugt ist vorgesehen, daß die Vorrichtung ein Flachbauteil mit mehreren aufeinander gefügten Bauteilebenen ist, die vorzugsweise in einem formfesten Körper angeordnet sind, wobei die dem natürlichen Licht zugewandte erste Ebene durch eine ein Magnetfeld durchlassende Platte mit einem Fenster für den Lichtdurchtritt zur Solarzelle ist, die zweite Ebene die Solarzelle nebst zugehöriger Leiterbahnen umfaßt, die dritte Ebene durch die Abschirmung des Datenträgers mit Schlitzausbildung gebildet ist, die vierte Ebene durch eine Einschubhalterung für einen Datenträger in Diskettenform gebildet ist, die fünfte Ebene die zweite Abschirmung nebst Schlitzdurchlaß für den Datenträger bildet und die sechste Ebene den mit dem Datenträger in Eingriff bringbaren Drehantrieb umfaßt, der mit den Leiterbahnen der Solarzelle kontaktiert ist.

Eine unter Umständen bevorzugte Ausbildung wird darin gesehen, daß der Antrieb, insbesondere Drehantrieb, des Datenträgers durch ein elektrisch angetriebenes Zahnrad mit Schrittantrieb und Rücklaufsperre gebildet ist.

Alternativ kann auch vorgesehen sein, daß der Antrieb, insbesondere Drehantrieb, des Datenträgers ein elektrischer Uhrantrieb ist.

Eine alternative Ausführungsform wird darin gesehen, daß der Datenträger eine Magnetbandkassette ist, die durch eine Abschirmung gegen ein durch Stoßströme erzeugtes Magnetfeld abgeschirmt ist, mit Ausnahme eines zwischen Umlenkrollen befindlichem aktuellen Meßbereiches.

Dabei ist bevorzugt vorgesehen, daß die Kassette mit einem Antrieb gekoppelt ist, der durch einen Magnetsensor einschaltbar ist, der im vom Stoßstrom durchflossenen Leiter erzeugten Magnetfeld liegt, wobei zudem vorzugsweise die Kassette im den Meßbereich verlassenden Magnetbandbereich einen Schreibkopf zur Aufzeichnung des Ereignisdatums auf das Magnetband sowie einen elektrischen Zähler zur Zählung der Anzahl der Ereignisse aufweist.

Eine alternative Möglichkeit zur Aufzeichnung von Überspannungsereignissen wird darin gesehen, daß der Datenträger durch einen optische Signale aufzeichnenden Aufnehmer gebildet ist, der mit einer durch Stoßströme energiesierbaren Lichtquelle, insbesondere einer LED, in einer bestimmbaren Zone belichtbar ist, wobei der Datenträger vorzugsweise als Scheibe oder Band mit Antriebsmitteln ausgebildet ist.

Dabei ist der optische Signale aufzeichnende Datenträger alternativ zu dem Datenträger gemäß Anspruch 1 vorgesehen, wobei zudem das Signal über ein Überspannungsereignis nicht durch unmittelbare Einwirkung und Aufzeichnung von Magnetfeldern gebildet wird, sondern das Überspannungsereignis wird durch die engergiesierbare Lichtquelle signalisiert.

Alternativ zu den vorbeschriebenen Lösungen kann auch vorgesehen sein, daß der elektrische Leiter mit einem über den Verlauf einer Erfassungszeit kontinuierlich oder diskontinuierlich relativ zur Datenzone verstellbaren das Magnetfeld der Datenzone im Ereignisfall beeinflußenden Element verbunden ist oder dieses Element bildet, so daß entsprechend dem Zeitablauf jeweils andere auf die erste mit Speicherdaten belegte Zone folgende mit Speicherdaten belegte Zonen in dem durch das Element bei auftretenden Stoßströmen im von Stoßstrom durchfließbaren elektronischen Leiter erzeugten Magnetfeld angeordnet sind.

Dabei kann auch vorgesehen sein, daß der Datenträger eine optisch beeinflußbare Datenzonte aufweist und das verstellbare Element eine optische Signalquelle, insbesondere eine Lichtquelle, ist, die durch auftretende Stoßströme im elektrischen Leiter energiesierbar ist.

Desweiteren kann alternativ zu den vorbeschriebenen Lösungen vorgesehen sein, daß die Vorrichtung aus einem im Stoßstromauftrittsfalle (Ereignisfalle) im Magnetfeld des des von Stoßstrom durchflossenen Leiters angeordneten Sensor besteht, der mit einem Microcomputer oder Microcontroller in leitender Verbindung steht, mittels dessen der Ereignisfall mindestens der Häufigkeit nach erfaßbar ist und der mit einem elektronischen Datenspeicher kommuniziert, mittels dessen die Ereignisse abrufbar aufzuzeichnen sind.

Dabei ist vorzugsweise vorgesehen, daß der Sensor ein Magnetsensor ist.

Bei allen Ausführungsformen kann zudem vorgesehen sein, daß auf dem Datenträger weitere, von Stoßströmen oder deren Begleiterscheinungen nicht löschbare Daten optisch oder mechanisch ablesbar abgelegt sind.

Auch kann bevorzugt vorgesehen sein, daß der Datenträger in miniaturisierter Form ausgebildet ist und an einem, vorzugsweise scheckkartengroßen, Adapter lösbar befestigbar ist.

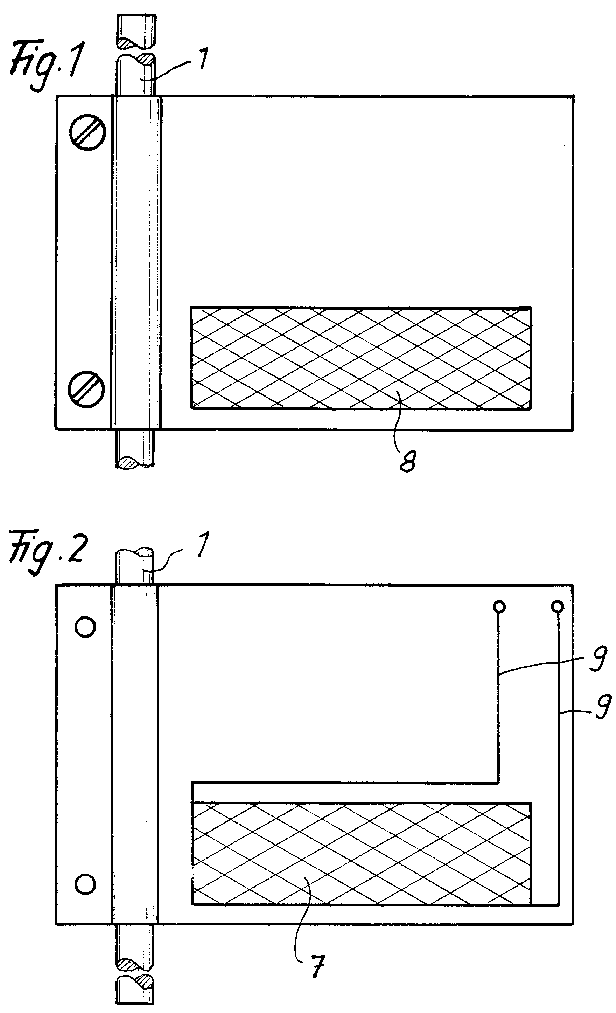

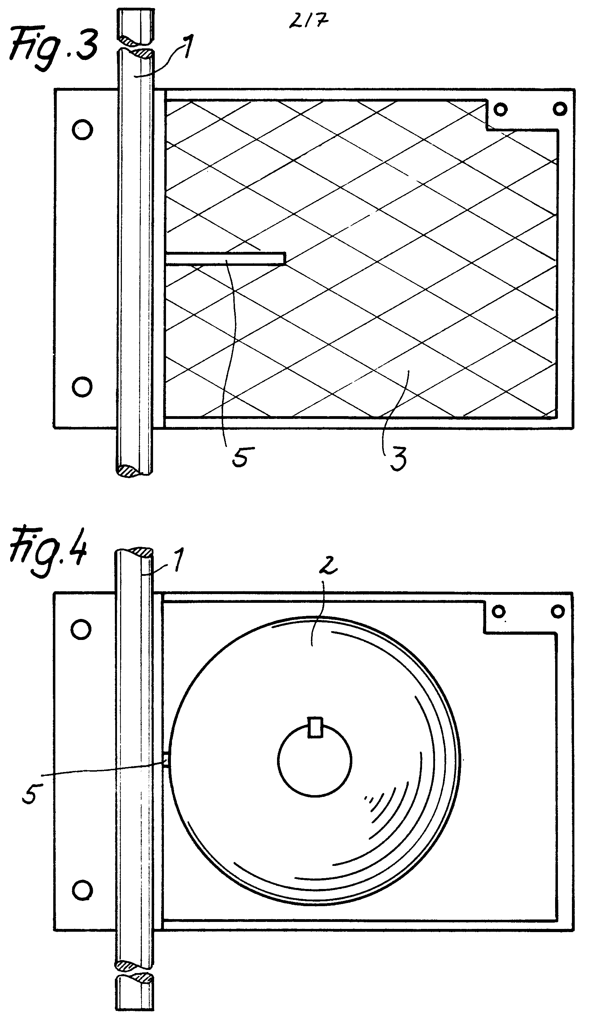

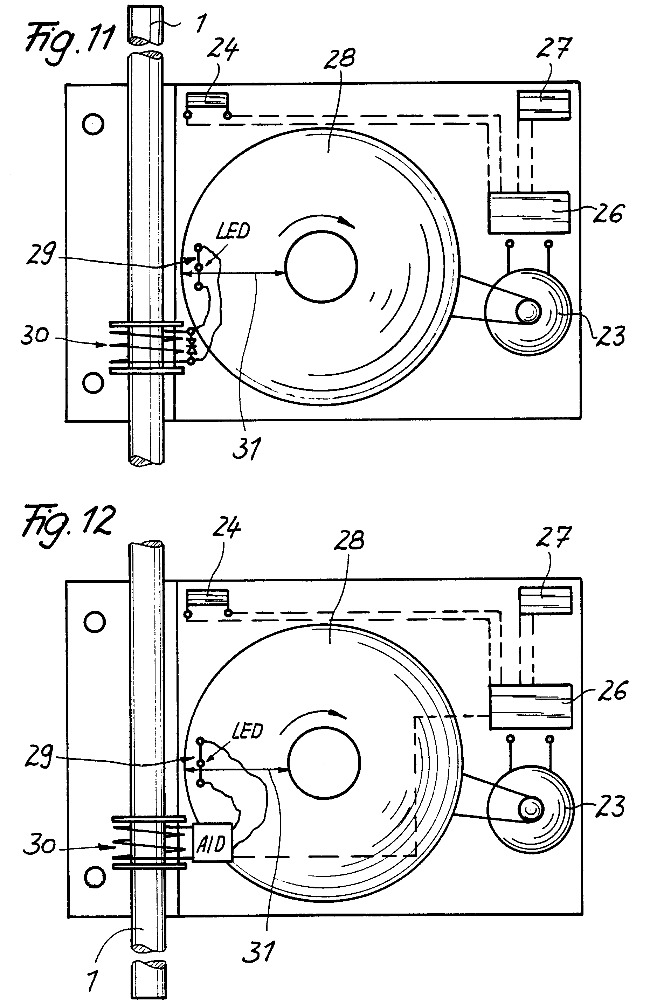

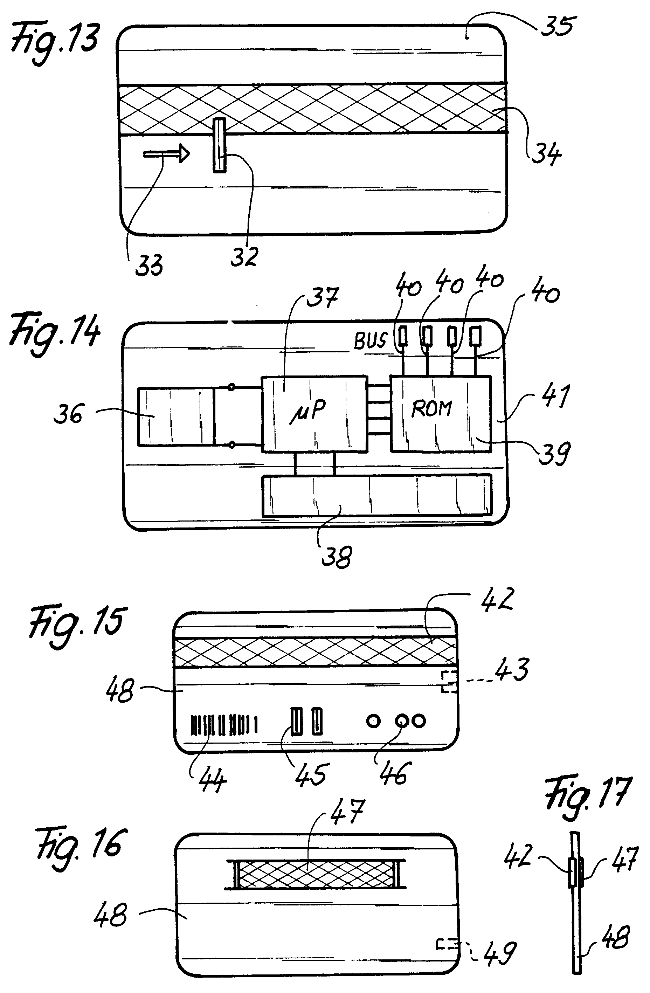

Ausführungsbeispiele der Erfindung sind in den Zeichnungs-figuren 1 bis 17 dargestellt und im folgenden näher beschrieben.

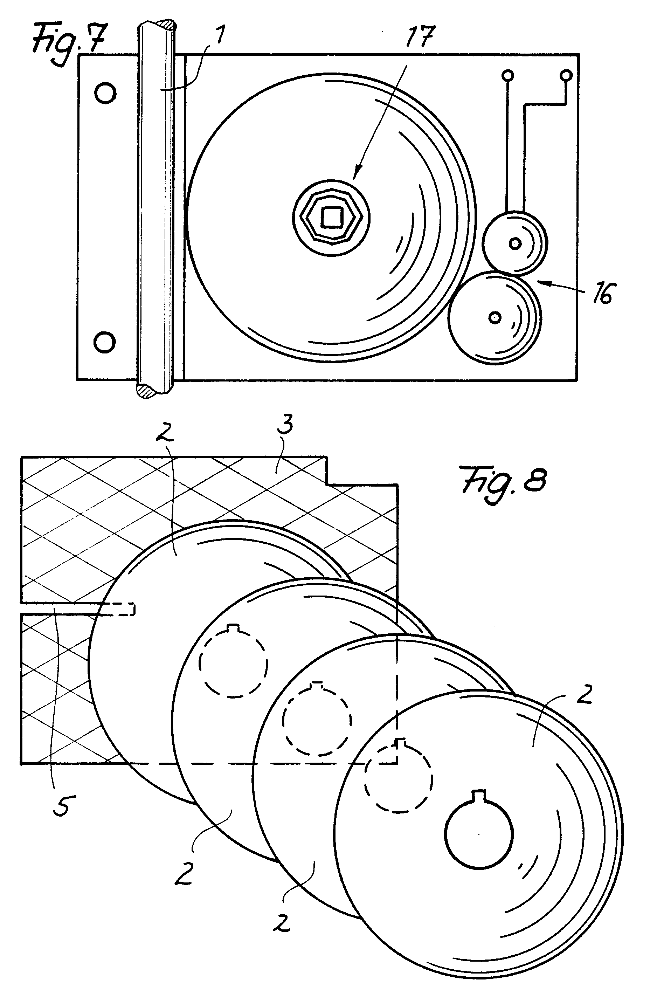

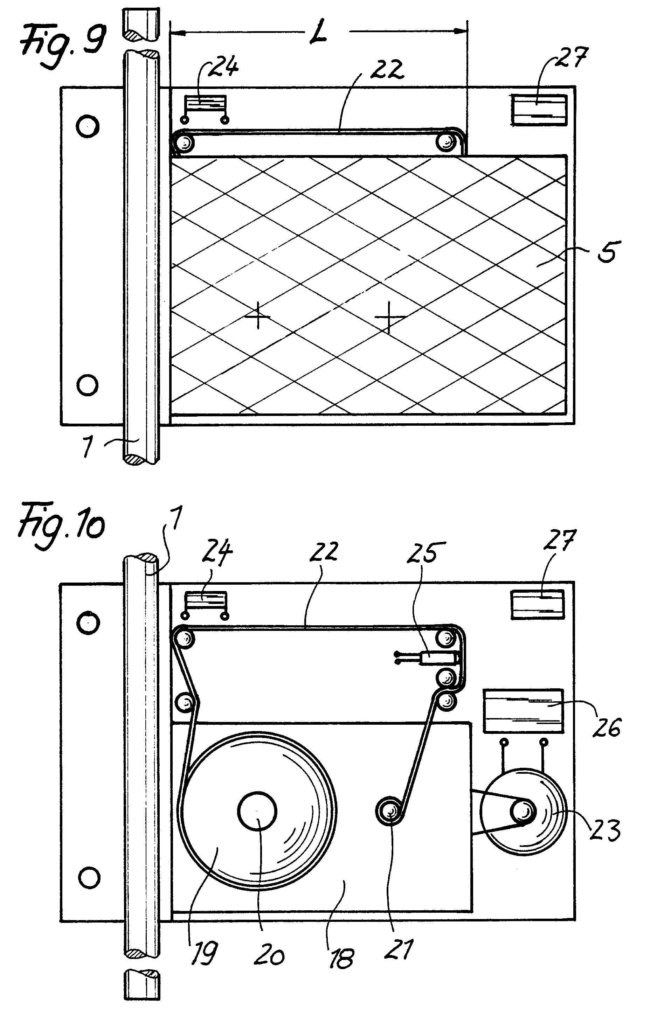

In Figur 1 bis 6 ist eine erste Ausführungsform dargestellt. Die Vorrichtung zur Erfassung von Stoßströmen an Blitzableitern, Überspannungsableitern oder anderen von Stoßströmen durchflossenen elektrischen Leitern 1 besteht gemäß diesem Ausführungsbeispiel aus einem mit Speicherdaten belegten magnetisierten Datenträger 2, der in einer räumlichen Zuordnung zu dem von Stoßströmen durchströmbaren elektrischen Leiter 1 angeordnet ist. Dazu ist ein später noch beschriebenes Gehäuse ausgebildet, welches an dem elektrischen Leiter 1 befestigbar ist. Die Anordnung des Datenträgers 2 erfolgt in der Weise an dem elektrischen Leiter 1, daß im Falle eines Stoßstromes eine mit Speicherdaten belegte Zone des Datenträgers 2 in dem durch den Stoßstrom um den Leiter 1 entstehenden Magnetfeld angeordnet ist. Der Datenträger 2 ist über einen beispielsweise in Figur 6 dargestellten Antrieb relativ zum elektrischen Leiter 1 kontinuierlich oder in Stufen diskontinuierlich über den Verlauf einer Erfassungszeitperiode drehbar, so daß entsprechend dem Zeitablauf jeweils andere auf die erste mit Speicherdaten belegte Zone folgende mit Speicherdaten belegte Zonen indem durch einen Stoßstrom um den Leiter 1 entstehenden Magnetfeld angeordnet sind.

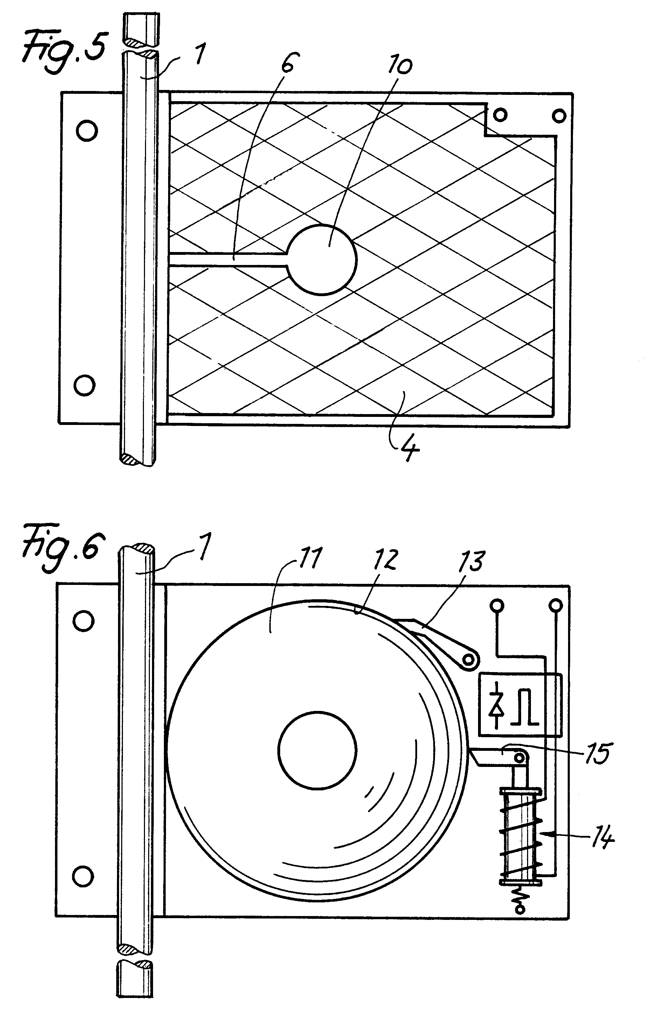

Der Datenträger ist im Ausführungsbeispiel gemäß Figur 4 eine mit einem Drehantrieb gemäß Figur 6 gekoppelte Scheibe. Der scheibenförmige Datenträger 2 ist quer von dem vom Stoßstrom durchströmbaren Leiter 1 abragend gehaltert, wobei die Fläche der Scheibe 2 in einer Ebene liegt, die auch von der Mittelachse des Leiters 1 gebildet ist. Gemäß Zeichnungsfigur 3 und 5 ist der Datenträger 2 an seiner großflächigen Ober- und Unterseite mit einer Abschirmung 3 bzw. 4 gegen das Magnetfeld des Leiters 1 versehen, wobei die Abschirmung 3 bzw. 4 lediglich eine schmalen zum Leiter 1 hin gerichteten Schlitz 5 bzw. 6 aufweist, der quasi von der Mitte des Datenträgers 2 radial bis zu der dem Leiter 1 zugewandten Randkante des Datenträger 2 verläuft. Durch diese Schlitze 5, 6 ist jeweils die mit Speicherdaten belegte Zone definiert, die in dem um den Leiter 1 entstehenden Magnetfeld von diesem beeinflußbar ist. Der übrige Bereiche des Datenträgers 2 ist durch die Abschirmung 3, 4 geschützt. Der Datenträger 2 ist zusätzlich mit einer eigenen Energiequelle in Form einer Solarzelle 7 zur Versorgung des Drehantriebes gemäß Figur 6 versehen. Die Solarzelle 7 ist durch eine bei der ersten Inbetriebnahme entfernbare Schutzfolie 8 abgedeckt. In der Zeichnungsfigur 1 ist die Vorderansicht einer entsprechenden Vorrichtung gezeigt. Die Vorrichtung ist als Flachbauelement ausgebildet und an dem entsprechenden Leiter 1 mit ihrer einen schmalen Randkante angeschlossen. Das Vorrichtungsgehäuse besteht beispielsweise aus Kunststoff. Die Frontfläche der Vorrichtung, die in Figur 1 ersichtlich ist, kann zur Kennzeichnung mit Buchstaben oder Zahlen genutzt werden. Sie weist auch ein Energieversorgungsfeld auf, welches zunächst herstellerseitig mit einer Schutzfolie 8 abgedeckt ist. Erst nach erfolgter Montage des Erfassungsgerätes wird die Schutzfolie 8 abgezogen und damit das Gerät aktiviert. Auf der Geräterückseite kann ein Beschriftungsfeld vorgesehen sein, in welchem das Datum der Inbetriebnahme festgehalten werden kann.

Die Gesamtvorrichtung ist ein Flachbauteil aus mehreren aufeinander gefügten Bauteilebenen, die in einem formfesten Körper angeordnet sind. Die dem natürlichen Licht zugewandte erste Ebene gemäß Figur 1 ist durch eine ein Magnetfeld durchlassende Platte gebildet. Die zweite Ebene besteht aus ebensolchem Material und umfaßt die Solarzelle 7 nebst zugehöriger Leiterbahnen 9. Die Leiterbahnen führen zu Übergabestellen, die durchkontaktierbar sind, so daß die Antriebseinheit gemäß Figur 6 mit der Solarzelle 7 in elektrisch leitender Verbindung gebracht werden kann.

Die dritte Ebene des Bauteiles ist gemäß Figur 3 durch die Abschirmung 3 des Datenträgers mit Schlitzausbildung 5 gebildet. Durch den Schlitz 5 wird der zu überschreibende Bereich des Datenträger 2 freigegeben. Durch die Gestaltung des Schlitzes kann sowohl der erfaßte Zeitabschnitt als auch die Empfindlichkeit festgelegt werden. In Zeichnungsfigur 3 rechts oben ist die Durchkontaktierung für die Stromzuführung erkennbar. Der Datenträger 2, der den eigentlichen Sensor darstellt, befindet sich in der vierten Ebene, die in Figur 4 gezeigt ist. Im Ausführunsbeispiel ist der Sensor eine vormagnetisierte Scheibe, wie sie beispielsweise in Disketten eingesetzt wird. Die Vormagnetisierung erfolgt in den Spuren, die dem offenen Schlitz 5 bis 6 entsprechen. Je nach Erfassungszeitraum können unterschiedliche Spurenzahlen vorhanden sein. Beispielsweise können 365 Spuren für die Erfassung eines Jahrenzeitraumes vorgesehen sein. Auch bei dieser Ebene ist die Durchkontaktierung oben rechts erkennbar.

In Figur 5 ist die fünfte Ebene gezeigt, die wiederum eine Abschirmung 4 mit entsprechender Schlitzausbildung 6 umfaßt. Die Abschirmung ist ferner im Mittelbereich bei 10 gelocht, da hier der Antrieb für den Datenträger 2 durchgreifen muß.

In Figur 6 ist der Antrieb des Datenträgers 2 prinzipiell dargestellt. Der Drehantrieb umfaßt eine drehbar gelagerte Scheibe 11, die analog zum Erfassungszeitraum Zahnungen aufweist, beispielsweise 365 Zahnungen im Randbereich 12. Eine Rücklaufsperre 13 sorgt dafür, daß die Scheibe 11 nur in einer Richtung bewegbar ist. Die Energie zum Antrieb des Antriebes der Scheibe 11 wird duch die Solarzelle direkt oder indirekt einem Hubmagneten 14 zugeführt, wobei bei Tageslicht die Scheibe um einen Zahn weiter bewegt wird. Bei Dunkelheit geht der Hubmagnet 14 wieder in die Ausgangsposition zurück. Bei auftretendem erneuten Tageslicht wird der Hubmagnet erregt und über den Eingriff der Klinke 15 die Scheibe entsprechend um eine Zahnung weitergedreht. Günstig auf die Belastung der Bauelement (Lebensdauer) können sich bekannte Schaltungen ausbilden, wie beispielsweise Triggerung (Schwellwert) oder auch Monoflops (nur 1 Impuls pro Tag). Mit diesen Schaltungen können natürlich auch die Arbeitsbedingungen der Vorrichtung festgelegt werden. In Figur 7 ist eine Variante des Antriebes gemäß Figur 6 gezeigt. Hierbei ist der Antrieb durch einen solarbetriebenen Uhrenantrieb 16 gebildet, wobei über entsprechend ausgelegte Zahnräder und Ritzel entsprechende Achse unterschiedlich gedreht werden. Ein solcher Uhrenantrieb ermöglicht auch die Anordnung von mehreren Datenträgern 2 übereinander, wobei jeder Datenträger von einem Achssegment im Mittelbereich 17 des Antriebes gemäß Figur 7 angetrieben wird. Die diskettenartigen Datenträger 2 können beispielsweise zur Aufzeichnung von Stunden, Tagen, Monaten und Jahren benutzt werden. Bezüglich des in Figur 4 gezeigten Bauteiles ist noch zu bemerken, daß der Datenträger 2 nach unten oder seitlich oder auch nach oben aus der Vorrichtung herausgeschoben werden kann, um den Datenträger 2 auszuwechseln.

Durch die erfindungsgemäße Ausbildung ist es möglich, den Datenträger 2 analog zur Zeitachse in seiner Position zu drehen, wobei der Antrieb der Zeitachse in beliebiger Form erfolgen kann, beispielsweise mechanisch, elektrisch, pneumatisch, hydraulisch oder auch chemisch.

Es ist auch möglich, den Drehantrieb oder dergleichen Antrieb durch einen von einem auftretenden Stoßstrom beeinflußbaren Schaltelement, z.B. einen Magnetschalter, zu steuern, so daß der Antrieb nur dann in Gang gesetzt wird, wenn ein Ereignisfall (Stoßstrom) aufgetreten ist. Damit verbunden könnte eine Datumseingabe vorgesehen sein, die ebenfalls durch den Ereignisfall in Gang gesetzt wird, so daß nicht nur der Ereignisfall, sondern auch die exakte Zeit des Ereignisses erfaßt und gespeichert werden kann.

Bei der der Ausführungform gemäß Figur 9 und 10 ist bei an sich ähnlichem Aufbau wie vor beschrieben anstelle des scheibenförmigen Datenträgers eine Magnetbandkassette 18 vorgesehen, die ein Magnetband 19 aufweist, welches von einer Wickelwelle 20 abwickelbar und auf eine andere Wickelwelle 21 aufwickelbar ist, wobei das Magnetband über Umlenkrollen geführt ist und in dem eigenen Meßbereich 22 radial zum elektrischen Leiter 1 verläuft. Auch hierbei ist eine Abschirmung 5 bzw. 6 vorhanden, die allerdings keinen Schlitz aufweist, sondern den eigentlichen Meßbereich 22 freiläßt. Die Länge des Meßbereiches ist bei L angegeben. Die Kassette 18 ist mit einem Antrieb 23 gekoppelt, der wiederum solarbetrieben sein kann. Der Antrieb 23 kann durch einen Magnetfeldsensor 24 eingeschaltet werden, der von dem um den Leiter 1 entstehenden Magnetfeld im Falle eines Überspannungsereignisses geschaltet wird. Es ist auch ein Permanentantrieb möglich. Desweiteren kann eine Schreibkopf 25 im Auslaufbereich des Meßbereiches 22 vorgesehen sein, mittels dessen auf dem Magnetband 19 ein Zeitmaßstab aufgebracht werden kann. Auch bei dieser Anordnung und Ausbildung ist es möglich, entsprechende Überspannungsereignisse der Anzahl und der Größe nach aufzuzeichnen und entsprechenden Zeiten zuzuordnen. Die Steuerung des Antriebes kann dabei mit einem Prozessor 26 gekoppelt sein, mittels dessen der Schreibkopf schaltbar ist und gegebenenfalls ein ebenfalls angeordneter Zähler 27 zur Zählung von Überspannungsereignissen in Gang gesetzt wird.

In der Ausführungsform gemäß Figur 11 ist ein Datenträger gezeigt, der durch einen optische Signale aufzeichnenden Aufnehmer 18 gebildet ist, beispielsweise einen Negativfilm. Auch hierbei ist wieder ein Antrieb 23, ein Prozessor 26, ein Zähler 27, ein Magnetsensor 24 vorgesehen, die über den Prozessor 26 verknüpft sind. Nach Auslösung des Magnetsensors kann der Antrieb 23 in Gang gesetzt werden. Desweiteren werden dann die Ereignisse gezählt. Die optische Erkennung erfolgt über eine LED 29, die elektrisch in geeigneter Weise bei 30 an den elektrischen Leiter 1 angekoppelt ist, so daß im Falle eines Überstromereignisses die LED je nach Stärke des Überspannungsereignisses heller oder dunkler leuchtet. Es wird auf diese Weise in dem entsprechenden Meßbereich 31, der durch einen Pfeil angegeben ist, das entsprechende Überspannungsereignis der Stärke nach aufgezeichnet, wobei durch Drehung des Aufnehmers 28 die zeitliche Zuordnung erfolgt.

In Figur 11 ist eine Kombination von magnetischer und optischer Aufzeichnungsmöglichkeit gezeigt, wobei dort der scheibenförmige Aufnehmer 28 als magnetisch optische Version ausgebildet ist. Auch hier erfolgt die Drehung der Scheibe 28 durch Ingangsetzung des Antriebes 23, der durch den Magnetsensor 24 im Ereignisfall ausgelöst wird. Die Schaltung wird durch den Prozessor 26 getriggert. Es kann auch die Aufzeichnung des Datums und die Zählung der Ereignisse im Zähler 27 erfolgen. Es kann eine magnet-optische Erkennung der Stromstärke erfolgen, wobei eine qualitativ auswertbare Aufzeichnung der Stromstärke über der Zeit erfolgt.

In Figur 13 ist eine andere Möglichkeit einer Ausbildung einer entsprechenden Vorrichtung gezeigt. Hierbei können magnetisch wirksame Elemente 32 in ihrer Position durch einen geeigneten Antrieb derart beispielsweise in Richtung des Pfeiles 33 verschoben werden, daß sie eine Aufzeichnungsspur 34 eines kartenförmigen Datenträgers 35 derart beeinflussen, daß eine zeitliche Zuordnung im Ereignisfall möglich ist. Eine weitere alternative ist in Figur 14 gezeigt. Dabei besteht die Vorrichtung aus einem im Magnetfeld des vom Stoßstrom durchflossenen Leiters 1 angeordneten Magentsensor 36, der mit einem Microcomputer 37 in leitender Verbindung steht. Der Microcomputer 37 ist über eine Stromversorgung 38, beispielsweise eine Solarzelle elektrisch versorgt. Der Microcomputer 37 steht zudem mit einem Datenspeicher (ROM) 39 in Verbindung, der über eine Busleitung 40 an ein Lesegerät anschließbar ist. Bei dieser Ausbildung können die vom Magnetsensor erfaßten Ereignisse verarbeitet und gegebenenfalls sowohl zeitlich als auch größenordnungsmäßig zugeordnet und in dem Datenspeicher 39 abgelegt werden. Auch bei dieser Ausbildung ist die Vorrichtung 41 insgesamt als Karte in Form und Größe einer Scheckkarte ausgebildet.

Auch bei den Ausbildungen gemäß Figur 15 bis 17 sind scheckkartenartige Ausbildungen vorgesehen. Dabei ist bei der Ausführungsform gemäß Figur 15 eine entsprechende Magnetspur 42 ausgebildet. Die Ausnehmung 43 ist eine Kodierung, die vom entsprechenden Lesegerät verarbeitet werden kann. Ergänzend sind hierbei zusätzliche Informationen tragende für ein Lesegerät optisch oder mechanisch abgreifbare Signale zu übermitteln. Beispielsweise können über einen Barcode 44 oder eine Prägung 45 oder auch Lochungen 46 Daten fest eingegeben werden, die in einem entsprechenden Lesegerät abgelesen werden können. Beispielsweise können hiermit Aufnahmeparameter, Eigenschaften der Magnetschicht, Aufnahmedaten, Serienzugehörigkeit, Frequenzgänge und andere wesentliche Informationen gespeichert werden. Die entsprechenden Kodierungen können durch optische Lesegeräte oder auch mechanische Abtastungen abgelesen werden.

Bei der Ausbildung gemäß Figur 16 und 17 ist der eigentliche Datenträger 47 nur ein Miniaturbauteil, welches die Anordnung an entsprechenden Leitern 1 in einfacher Weise ermöglicht. Allerdings ist diese Größe für die Handhabe insbesondere bei Lesegeräten nicht besonders vorteilhaft, so daß bei dieser Ausführungsform vorgesehen ist, daß der Datenträger 47 an einem scheckkartengroßen Adapter 48 lösbar befestigt ist, beispielsweise angeclipst ist. Der Adapter 48 weist eine Kodierung 49 auf, die vom Lesegerät auswertbar ist, so daß das Lesegerät erfassen kann, daß es sich um eine Miniaturisierung eines Datenträgers 47 handelt. Somit ist es möglich, auch solche kleinbauenden Magnetkarten in dem gleichen Lesegerät auszuwerten, wie Magnetkarten der Ausführungsform beispielsweise gemäß Figur 15.

Die Erfindung ist nicht auf die Ausführungsbeispiele beschränkt, sondern im Rahmen der Offenbarung vielfach variabel.

Alle neuen, in der Beschreibung und/oder Zeichnung offenbarten Einzel- und Kombiantionsmerkmale werden als erfindungswesentlich angesehen.

## Patentansprüche

1. Vorrichtung zur Erfassung von Stoßströmen an Blitzableitern, Überspannungsableitern oder anderen von Stoßströmen oder von impulsförmigen Strömen (Kurzschluß- oder Erdschlußströmen) durchflossenen elektrischen Leitern, wobei ein mit Speicherdaten belegter magnetisierbarer Datenträger in einer räumlichen Zuordnung zu einem von Stoßströmen durchströmbaren elektrischen Leiter angeordnet ist, so daß im Falle eines Stoßstromes mindestens eine mit Speicherdaten belegte Zone des Datenträgers in dem durch den Stoßstrom um den Leiter entstehenden Magnetfeld angeordnet ist, **dadurch gekennzeichnet**, **daß** der Datenträger (2) relativ zum elektrischen Leiter (1) kontinuierlich oder in Stufen diskontinuierlich über den Verlauf einer Erfassungszeit derart verstellbar ist, daß entsprechend dem Zeitablauf jeweils andere auf die erste mit Speicherdaten belegte Zone folgende mit Speicherdaten belegte Zonen in dem durch einen Stoßstrom um den Leiter (1) entstehenden Magnetfeld angeordnet sind.

2. Vorrichtung nach Anspruch 1, **dadurch gekennzeichnet**, **daß** der Datenträger (2) eine mit einem Drehantrieb gekoppelte Scheibe ist.

3. Vorrichtung nach Anspruch 1 oder 2, **dadurch gekennzeichnet, daß** der Datenträger (2) scheiben- oder plattenförmig ausgebildet und quer von einem von Stoßstrom durchströmbaren Leiter (1) abragend gehaltert ist, wobei der Datenträger (2) an seiner großflächigen Ober- und Unterseite mit einer Abschirmung (3,4) zur Abschirmung gegen das Magnetfeld des Leiters (1) versehen ist, die lediglich einen schmalen, zum Leiter (1) hin gerichteten Schlitz (5,6) aufweist, durch den jeweils die mit Speicherdaten belegte Zone definiert ist, die in dem um den Leiter (1) entstehenden Magnetfeld von diesem beeinflußt ist.

4. Vorrichtung nach einem der Ansprüche 1 bis 3, **dadurch gekennzeichnet, daß** der Datenträger (2) mit einer eigenen Energiequelle, vorzugsweise einer Solarzelle (7), zur Versorgung des Drehantriebes ausgestattet ist.

5. Vorrichtung nach einem der Ansprüche 1 bis 4, **dadurch gekennzeichnet, daß** die Solarzelle (7) durch eine bei Inbetriebnahme entfernbare Schutzfolie (8) abgedeckt ist.

6. Vorrichtung nach einem der Ansprüche 1 bis 5, **dadurch gekennzeichnet, daß** ein Flachbauteil mit mehreren aufeinander gefügten Bauteilebenen ist, die vorzugsweise in einem formfesten Körper angeordnet sind, wobei die dem natürlichen Licht zugewandte erste Ebene durch eine ein Magnetfeld durchlassende Platte mit einem Fenster für den Lichtdurchtritt zur Solarzelle ist (Fig.1), die zweite Ebene die Solarzelle (7) nebst zugehöriger Leiterbahnen umfaßt (Fig.2), die dritte Ebene durch die Abschirmung (3) des Datenträgers (2) mit Schlitzausbildung (5) gebildet ist (Fig.3), die vierte Ebene durch eine Einschubhalterung für einen Datenträger (2) in Diskettenform gebildet ist (Fig.4) die fünfte Ebene die zweite Abschirmung (4) nebst Schlitzdurchlaß (6) für den Datenträger (2) bildet (Fig.5) und die sechste Ebene den mit dem Datenträger in Eingriff bringbaren Drehantrieb umfaßt, der mit den Leiterbahnen der Solarzelle (7) kontaktiert ist (Fig.6).

7. Vorrichtung nach einem der Ansprüche 1 bis 6, **dadurch gekennzeichnet, daß** der Antrieb, insbesondere Drehantrieb, des Datenträgers (2) durch ein elektrisch angetriebenes Zahnrad (11) mit Schrittantrieb (14,15) und Rücklaufsperre (13) gebildet ist.

8. Vorrichtung nach einem der Ansprüche 1 bis 6, **dadurch gekennzeichnet, daß** der Antrieb, insbesondere Drehantrieb, des Datenträgers (2) ein elektrischer Uhrantrieb (16) ist.

9. Vorrichtung nach Anspruch 1, **dadurch gekennzeichnet, daß** der Datenträger eine Magnetbandkassette (18) ist, die durch eine Abschirmung (5,6) gegen ein durch Stoßströme erzeugtes Magnetfeld abgeschirmt ist, mit Ausnahme eines zwischen Umlenkrollen befindlichem aktuellen Meßbereiches (22).

10. Vorrichtung nach Anspruch 9, **dadurch gekennzeichnet, daß** die Kassette (18) mit einem Antrieb (23) gekoppelt ist, der durch einen Magnetsensor (24) einschaltbar ist, der im vom Stoßstrom durchflossenen Leiter (1) erzeugten Magnetfeld liegt, wobei zudem vorzugsweise die Kassette (18) im den Meßbereich (22) verlassenden Magnetbandbereich einen Schreibkopf (25) zur Aufzeichnung des Ereignisdatums auf das Magnetband sowie einen elektrischen Zähler (27) zur Zählung der Anzahl der Ereignisse aufweist.

11. Vorrichtung nach einem der Ansprüche 1 bis 10, **dadurch gekennzeichnet, daß** der Datenträger durch einen optische Signale aufzeichnenden Aufnehmer (28) gebildet ist, der mit einer durch Stoßströme energiesierbaren Lichtquelle (29), insbesondere einer LED, in einer bestimmbaren Zone (31) belichtbar ist, wobei der Datenträger vorzugsweise als Scheibe oder Band mit Antriebsmitteln (28) ausgebildet ist.

12. Vorrichtung zur Erfassung von Stoßströmen an Blitzableitern, Überspannungsleitern oder anderen von Stoßströmen durchflossenen elektrischen Leitern, wobei ein mit Speicherdaten belegter, magnetisierbarer Datenträger angeordnet ist, dessen Datenspur oder Datenzone durch das Magnetfeld eines von Stoßströmen durchflossenen elektrischen Leiters beeinflußbar ist, **dadurch gekennzeichnet, daß** der elektrische Leiter (1) mit einem über den Verlauf einer Erfassungszeit kontinuierlich oder diskontinuierlich relativ zur Datenzone (34) verstellbaren das Magnetfeld der Datenzone im Ereignisfall beeinflußenden Element (32) verbunden ist oder dieses Element bildet, so daß entsprechend dem Zeitablauf jeweils andere auf die erste mit Speicherdaten belegte Zone folgende mit Speicherdaten belegte Zonen in dem durch das Element (32) bei auftretenden Stoßströmen im von Stoßstrom durchfließbaren elektrischen Leiter (1) erzeugten Magnetfeld angeordnet sind.

13. Vorrichtung nach Anspruch 12, **dadurch gekennzeichnet, daß** der Datenträger eine optisch beeinflußbare Datenzone (34) aufweist und das verstellbare Element (32) eine optische Signalquelle, insbesondere eine Lichtquelle, ist, die durch auftretende Stoßströme im elektrischen Leiter (1) energiesierbar ist.

14. Vorrichtung zur Erfassung von Stoßströmen an Blitzableitern, Überspannungsableitern oder anderen von Stoßströmen durchflossenen elektrischen Leiter, **dadurch gekennzeichnet, daß** die Vorrichtung aus einem im Stoßstromauftrittsfall (Ereignisfall) im Magnetfeld des von Stoßstrom durchflossenen Leiters (1) angeordneten Sensor (36) besteht, der mit einem Microcomputer (37) oder Microcontroller in leitender Verbindung steht, mittels dessen der Ereignisfall mindestens der Häufigkeit nach erfaßbar ist und der mit einem elektronischen Datenspeicher (39) kommuniziert, mittels dessen die Ereignisse abrufbar aufzuzeichnen sind.

15. Vorrichtung nach Anspruch 14, **dadurch gekennzeichnet, daß** der Sensor (36) ein Magnetsensor ist.

16. Vorrichtung nach einem der Ansprüche 1 bis 15, **dadurch gekennzeichnet, daß** auf dem Datenträger weitere, von Stoßströmen oder deren Begleiterscheinungen nicht löschbare Daten (44,45,46) optisch oder mechanisch ablesbar abgelegt sind.

17. Vorrichtung nach einem der Ansprüche 1 bis 16, **dadurch gekennzeichnet, daß** der Datenträger (47) in miniaturisierter Form ausgebildet ist und an einem, vorzugsweise scheckkartengroßen, Adapter (48) lösbar befestigbar ist.
